(19) Europäisches Patentamt
European Patent Office
Office européen des brevets

(11) **EP 1 450 489 B1**

(12) **EUROPÄISCHE PATENTSCHRIFT**

(45) Veröffentlichungstag und Bekanntmachung des Hinweises auf die Patenterteilung:
**06.01.2010 Patentblatt 2010/01**

(51) Int Cl.:
*H03K 17/96* (2006.01)    *G07C 9/00* (2006.01)
*B60J 5/04* (2006.01)

(21) Anmeldenummer: **04003806.9**

(22) Anmeldetag: **19.02.2004**

(54) **Auslösesignalgeber**

Release trigger

Générateur d'un signal de déclenchement

(84) Benannte Vertragsstaaten:
**DE FR**

(30) Priorität: **21.02.2003 DE 10307673**

(43) Veröffentlichungstag der Anmeldung:
**25.08.2004 Patentblatt 2004/35**

(73) Patentinhaber: **Huf Hülsbeck & Fürst GmbH & Co. KG**
**42551 Velbert (DE)**

(72) Erfinder: **van Gastel, Peter**
**42699 Solingen (DE)**

(74) Vertreter: **Eggers, Thomas Peter et al**
**Huf Hülsbeck & Fürst GmbH & Co. KG**
**Steeger Straße 17**
**42551 Velbert (DE)**

(56) Entgegenhaltungen:
**EP-A- 1 245 761    DE-A- 10 206 968**
**US-A- 6 075 294**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft einen Auslösesignalgeber, beispielsweise zur Einleitung eines Frage-/Antwort-Dialogs im Rahmen einer Zugangsberechtigungsprüfung bei einem Kraftfahrzeug, zur Betätigung eines Kraftfahrzeugtürverschlusses oder dergleichen, mit wenigstens einem ersten und einem zweiten jeweils kapazitiv arbeitenden Sensor, wobei der erste Sensor als Auslösesensor ausgebildet ist und ein Auslösesignal erzeugt.
Ein derartiger Auslösesignalgeber wird beispielhaft im Rahmen der EP 1 235 190 A1 beschrieben. Hier ist auch die grundsätzliche Funktionsweise solcher kapazitiv arbeitender Sensoren erläutert. Diese beruht darauf, dass bei Annäherung einer Bedienperson die Kapazität des betreffenden Sensors eine Änderung erfährt. Das erreicht man in der Regel dadurch, dass sowohl der erste als auch der zweite Sensor jeweils über eine Leitfähigkeitselektrode verfügen, wohingegen beispielsweise die Hand oder ein anderes Körperteil des Bedieners die Gegenelektrode darstellt. Sobald sich der Bediener annähert, ändert sich der Abstand der beiden Elektroden und infolgedessen steigt in der Regel die Kapazität des solchermaßen gebildeten Kondensators an.
Hieraus resultierende Kapazitätsänderungen lassen sich auswerten und im Rahmen des Auslösesignalgebers dahingehend nutzen, dass ein Auslösebefehl erzeugt wird. Dieser Auslösebefehl mag die eingangs beschriebene Zugangsberechtigungsprüfung und damit einhergehend eine Datenabfrage zwischen einem bedienerseitigen Datenträger und einer kraftfahrzeugseitigen Steuereinrichtung initiieren. Bei dem bedienerseitigen Datenträger kann es sich um einen mobilen Transponder, z. B. einen elektronischen Schlüssel oder eine Chipkarte, handeln. Genauso gut lässt sich der Auslösebefehl dazu nutzen, beispielsweise einen oder mehrere elektromotorisch angetriebene Kraftfahrzeugtürverschlüsse zu öffnen (oder auch zu verriegeln). In der Regel setzt man den Auslösebefehl an dieser Stelle jedoch dazu ein, eine Sperrklinke beispielsweise eines Kraftfahrzeug-Heckklappenschlosses elektromotorisch auszuheben, ohne dass ein Frage-/Antwort-Dialog vorangegangen sein muss.
Im weiteren Stand der Technik nach der DE 196 20 059 A1 ist bereits die Möglichkeit diskutiert worden, umweltbedingte Kapazitätsänderungen des einen oder der beiden Sensoren zu beherrschen. Solche Kapazitätsänderungen lassen sich meistens darauf zurückführen, dass die Leitfähigkeitselektrode mit einem Flüssigkeitsfilm aus Wasser in Folge von beispielsweise Regen, Eis oder Schnee überzogen wird. Dieser Flüssigkeitsfilm wirkt in der Regel als Dielektrikum im Sinne einer Kapazitätserhöhung und damit in die gleiche Richtung wie die Annäherung eines Bedieners.
Das heißt, die zuvor beschriebenen Umwelteinflüsse können beispielhaft zu Fehlauslösungen führen bzw. einen Auslösebefehl erzeugen, der überhaupt nicht beabsichtigt war. Das macht sich insbesondere dann negativ bemerkbar, wenn der beschriebene Auslösesignalgeber zum elektromotorischen Ausheben einer Sperrklinke beispielsweise eines Kraftfahrzeug-Heckklappenschlosses genutzt wird. Denn dann besteht die Gefahr, dass die Heckklappe unbeabsichtigt und zufällig in die Position "offen" verbracht wird. Das kann ohne besondere Vorkehrungen schon in der Waschstraße oder während der Fahrt erfolgen.
Aus diesem Grund schlägt die bereits genannte DE 196 20 059 A1 vor, den dortigen Sensor als dynamischen kapazitiven Näherungsschalter auszuführen, der nur dann schaltet, wenn sich die Kapazität zwischen einer Ansprechelektrode und einer Bezugselektrode mit einer bestimmten Geschwindigkeit ändert, die größer als ein unterer Grenzwert ist. Aber auch hier lassen sich Fehlfunktionen nicht ausschließen. Denn wenn beispielsweise ein Bediener mit seiner Hand in der Nähe der zuvor beschriebenen Ansprechgeschwindigkeit arbeitet, können indifferente Funktionszustände bzw. eine Nichtauslösung die Folge sein. Das ist für den betreffenden Bediener nicht nachzuvollziehen. Hinzu kommt, dass solche Lösungen wenig komfortabel sind, insbesondere dann, wenn verschiedene Nutzer zu ein und demselben Fahrzeug Zugang begehren, wie dies beispielsweise bei Mietwagen oder Firmenwagen der Fall ist. - Hier will die Erfindung insgesamt Abhilfe schaffen.
Der Erfindung liegt das technische Problem zugrunde, einen Auslösesignalgeber der eingangs beschriebenen Gestaltung so weiter zu entwickeln, dass umweltbedingte Fehlfunktionen in jedem Fall ausgeschlossen werden können und Komfortbeeinträchtigungen nicht zu verzeichnen sind.
Ein Auslösesignalgeber nach dem ersten Teil des unabhängigen Anspruchs ist aus US 6 075 294 bekannt.
Zur Lösung dieser technischen Problemstellung schlägt die Erfindung bei einem gattungsgemäßen Auslösesignalgeber vor, dass der zweite Sensor als lediglich auf Umwelteinflüsse reagierender Umweltsensor ausgebildet ist und ein Umweltsignal abgibt, wobei in Abhängigkeit vom Umweltsignal aus dem Auslösesignal ein Auslösebefehl abgeleitet wird. Dem Umweltsignal kommt also im Vergleich zu dem Auslösesignal die Priorität zu. Je nach dem wie dieses Umweltsignal gestaltet ist, wird überhaupt erst aus dem Auslösesignal ein Auslösebefehl abgeleitet, so dass dann beispielsweise der zuvor beschriebene Frage-/Antwort-Dialog initiiert wird oder es zu einer Betätigung des Kraftfahrzeugtürverschlusses kommt.
Das Umweltsignal kann in einer ersten Ausführungsvariante im Wesentlichen zwei Zustände einnehmen, nämlich als Freigabe- oder Sperrsignal für das Auslösesignal wirken. Ein Freigabesignal bedeutet, dass letztlich kein Umweltsignal erzeugt wird, d. h. umweltbedingte Kapazitätsänderungen nicht vorliegen. Dagegen korrespondiert das Sperrsignal zu der Situation, dass ein Umweltsignal vorliegt, mithin umweltbedingte Kapazitätsänderungen Berücksichtigung finden müssen. Sofern also solche umweltbedingten Kapazitätsänderungen zu berücksichtigen sind, liegt ein Umweltsignal und folglich ein Sperrsignal vor.

Dieses Sperrsignal sorgt dafür, dass insgesamt kein Auslösebefehl ausgegeben wird. Das heißt, bei Vorliegen des Sperrsignals am Umweltsensor wird kein Auslösebefehl erzeugt, und zwar ungeachtet dessen, ob der Auslösesensor ein Auslösesignal abgibt oder nicht. Diese Bedingung gilt selbstverständlich auch dann, wenn das Sperrsignal und beispielsweise ein Auslösesignal zeitgleich vorliegen.

In der Regel wird ein eventuelles Auslösesignal erst nach einer einstellbaren Verzögerungszeit in einen Auslösebefehl umgewandelt. Diese Verzögerungszeit sorgt dafür, dass zuvor der Umweltsensor einwandfrei von seinem Status her erfasst werden kann. Liegt ein Umweltsignal und mithin Sperrsignal vor, so wird der Auslösesensor und folglich ein Auslösesignal - ob es nun vorhanden ist oder nicht - gleichsam ignoriert. Jedenfalls sorgt die Verzögerungszeit dafür, dass der die Priorität bildende Umweltsensor fehlerfrei ausgelesen werden kann.

Der Beginn der Verzögerungszeit fällt dabei in der Regel mit dem Start des Auslösesignals zusammen. Das heißt, sobald der Auslösesensor ein Auslösesignal erzeugt, startet die Verzögerungszeit, innerhalb derer der Umweltsensor ausgelesen wird. Liegt ein Umweltsignal und mithin Sperrsignal vor, so wird kein Auslösebefehl abgeleitet. Nur dann, wenn der Umweltsensor kein Umweltsignal erzeugt und folglich ein Freigabesignal abgibt, führt die Auslösung des Auslösesensors auf einen Auslösebefehl, der in die entsprechenden Maßnahmen umgewandelt wird.

Es hat sich bewährt, eine Steuer-/Auswerteeinheit vorzusehen, welche beide Signale der Sensoren auswertet, wobei - wie gesagt - dem Umweltsignal die Priorität zukommt. Diese Steuer-/Auswerteeinheit gibt zudem die zuvor beschriebene Verzögerungszeit vor und erfasst gleichzeitig die Kapazitätsänderungen an den betreffenden Sensoren. Diese mögen beispielsweise dadurch ermittelt werden, dass der jeweils betreffende Sensor auf- und/oder entladen wird. Aus den zugehörigen Aufladezeiten und/oder Entladezeiten lässt sich zuverlässig auf etwaige Kapazitätsänderungen, insbesondere Kapazitätserhöhungen, rückschließen.

Denn die mit Umweltstörungen einhergehenden Kapazitätsänderungen führen dazu, dass sowohl die Aufladezeit als auch die Entladezeit unter Berücksichtigung eines bestimmten Schwellwertes eine Variation erfahren. Beispielsweise lässt sich eine sogenannte Zeitkonstante ermitteln, die dazu korrespondiert, dass ein Kondensator auf ca. 63 % vom Höchstwert seiner Kapazität geladen bzw. auf ca. 37 % vom Höchstwert der Kapazität entladen ist. Diese Zeitkonstante errechnet sich als Produkt der Kapazität des Kondensators und der Größe des Ladewiderstandes (welche im Wesentlichen konstant ist). Steigt die Kapazität, so wird die entsprechende Zeitkonstante wegen der zuvor angegebenen Produktbeziehung größer und kann leicht ausgewertet werden. Dadurch ist die vorgenannte Zeitkonstante bzw. deren Änderungen ein Maß für die zu registrierenden Kapazitätsänderungen, die wiederum die genannten Signale erzeugen.

Es hat sich als günstig erwiesen, den Auslösesensor und den Umweltsensor in unmittelbarer Nähe zueinander anzuordnen und hier beispielsweise eine gegenseitige konzentrische Anordnung zu wählen. Dabei findet sich der Auslösesensor in der Regel in der Mitte und mag die Gestalt einer Kreisscheibe annehmen, während der Umweltsensor die betreffende Kreisscheibe als Ring konzentrisch umgibt. Sowohl der Auslösesensor als auch der Umweltsensor können im Türgriff, an oder in der Heckklappe, in oder an einem Stoßfänger oder an anderen Einbauorten des Kraftfahrzeuges getrennt oder gemeinsam angebracht werden. Das heißt, es ist möglich, beispielsweise den Umweltsensor in oder an dem Stoßfänger zu platzieren, während der Auslösesensor im Türgriff befindlich ist.

Im Ergebnis wird ein Auslösesignalgeber zur Verfügung gestellt, der umweltbedingte Einflüsse vollständig eliminiert. Denn bevor ein Auslösebefehl zur Einleitung eines Frage-/Antwort-Dialoges oder zur Betätigung eines Kraftfahrzeugtürverschlusses überhaupt erzeugt wird, erfährt zunächst der Umweltsensor eine Auswertung. Liegt an dieser Stelle ein Umweltsignal vor, d. h. sind umweltbedingte Kapazitätsänderungen zu berücksichtigen, so korrespondiert dieses Umweltsignal zu einem Sperrsignal für das Auslösesignal. Das heißt, in diesem Fall wird kein Auslösebefehl erzeugt.

Wenn dagegen der Umweltsensor kein Umweltsignal abgibt, d. h. umweltbedingte Kapazitätsänderungen nicht oder nur in geringem Maße vorliegen, korrespondiert dieses Umweltsignal zu einem Freigabesignal für das Auslösesignal, so dass aus dem Auslösesignal ein Auslösebefehl abgeleitet wird. Dabei versteht es sich, dass die von den Sensoren jeweils registrierten Kapazitätsänderungen mit Schwellwerten flankiert werden. Das heißt, die Kapazitätsänderungen werden erst dann in entsprechende Signale umgewandelt, wenn ein in der Regel von der Steuer-/Auswerteeinheit vorgegebener Schwellwert der Kapazitätsänderung überschritten wird. Dabei versteht es sich, dass der Umweltsensor im Allgemeinen mit einer höheren Empfindlichkeit als der Auslösesensor ausgestattet ist. Anders ausgedrückt, liegt der Schwellwert für registrierte Kapazitätsänderungen beim Umweltsensor niedriger als beim Auslösesensor. Hierin sind die wesentlichen Vorteile zu sehen.

In einer zweiten Ausführungsvariante kann der Umweltsensor dazu dienen, in Abhängigkeit von den Umweltbedingungen die Empfindlichkeit des Auslösesensors einzustellen.

Dabei nimmt das Umweltsignal an Stelle des Zustandes Sperrsignal bei Vorliegen eines Umweltsignales den Zustand Einstellsignal ein. Das Einstellsignal sorgt dafür, dass die Steuer-/Auswerteeinheit dieses Signal auswertet und in Abhängigkeit von dem Einstellsignal eine Einstellung der Empfindlichkeit des Auslösesensors erfolgt. Ein Auslösebefehl erfolgt in diesem Fall erst dann, wenn der von der Steuer-/Auswerteeinheit neu eingestellte Schwellwert durch eine Kapazitätsänderung am Auslösesensor überschritten wird und ein Auslösesignal anliegt.

Wenn dagegen der Umweltsensor kein Umweltsignal abgibt, d. h. umweltbedingte Kapazitätsänderungen nicht oder nur in geringem Maße vorliegen, korrespondiert dieses Umweltsignal wie bei der ersten Ausführungsvariante zu einem Freigabesignal für das Auslösesignal, so dass aus dem Auslösesignal ein Auslösebefehl abgeleitet wird.

Vorteil dieser Ausführungsvariante ist, dass durch Umweltbedingungen hervorgerufene Kapazitätsänderungen an den Sensoren die Funktionsfähigkeit des Auslösesignalgebers nicht beeinflussen, d. h. ein Auslösebefehl auch bei widrigen Umweltbedingungen generiert werden kann.

Im Folgenden wird die Erfindung anhand einer lediglich ein Ausführungsbeispiel darstellenden Zeichnung näher erläutert; es zeigen:

Fig. 1   den Auslösesensor und den Umweltsensor schematisch,

Fig. 2   die Signalverläufe der beiden Sensoren nach Fig. 1 bei einem Öffnungsvorgang,

Fig. 3 und 4   mögliche Situationen, die nicht zur Ausgabe eines Auslösebefehls resultieren und

Fig. 5   die entsprechenden Signalverläufe hierzu, d. h. eine Situation, in welcher kein Auslösebefehl erzeugt wird.

Im Rahmen des Ausführungsbeispiels wird in einer ersten Ausführungsvariante ein Auslösesignalgeber gezeigt, der in einer Heckleuchte untergebracht ist, wobei natürlich auch andere Anordnungen und topologische Ausgestaltungen denkbar sind. Der Auslösesignalgeber dient im Rahmen der Darstellung dazu, ein nicht ausdrücklich gezeigtes Schloss bzw. einen Kraftfahrzeugtürverschluss an einer Heckklappe elektromotorisch zu öffnen. Dazu verfügt der Auslösesignalgeber in seinem grundsätzlichen Aufbau über einen ersten Sensor 1 und einen zweiten Sensor 2, die beide kapazitiv arbeiten. Bei dem ersten Sensor 1 handelt es sich um einen Auslösesensor 1, welcher ein Auslösesignal erzeugt, während der zweite Sensor 2 lediglich auf Umwelteinflüsse reagiert und als Umweltsensor 2 ausgebildet ist sowie ein Umweltsignal abgibt.

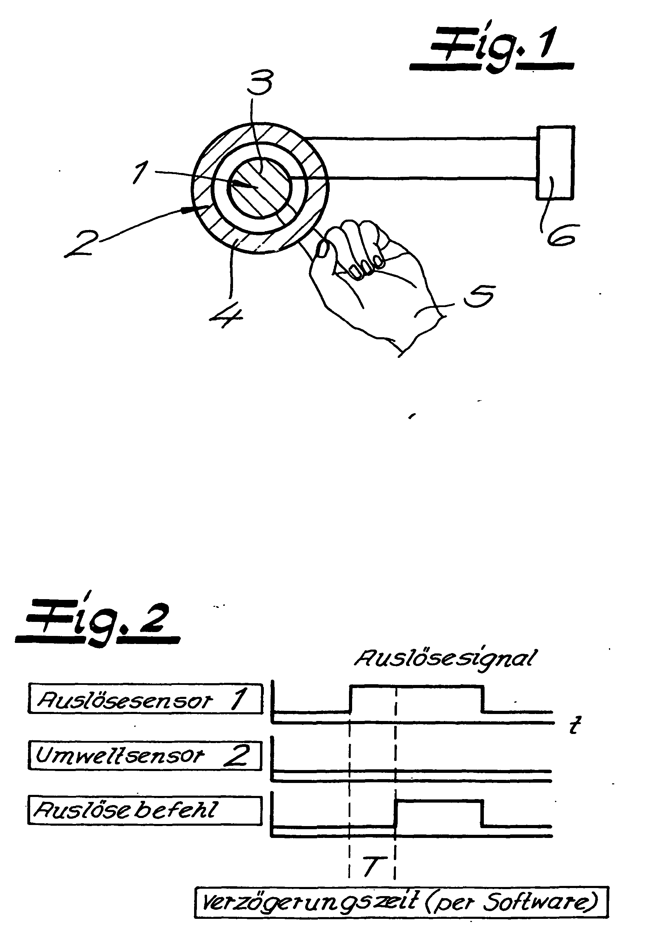

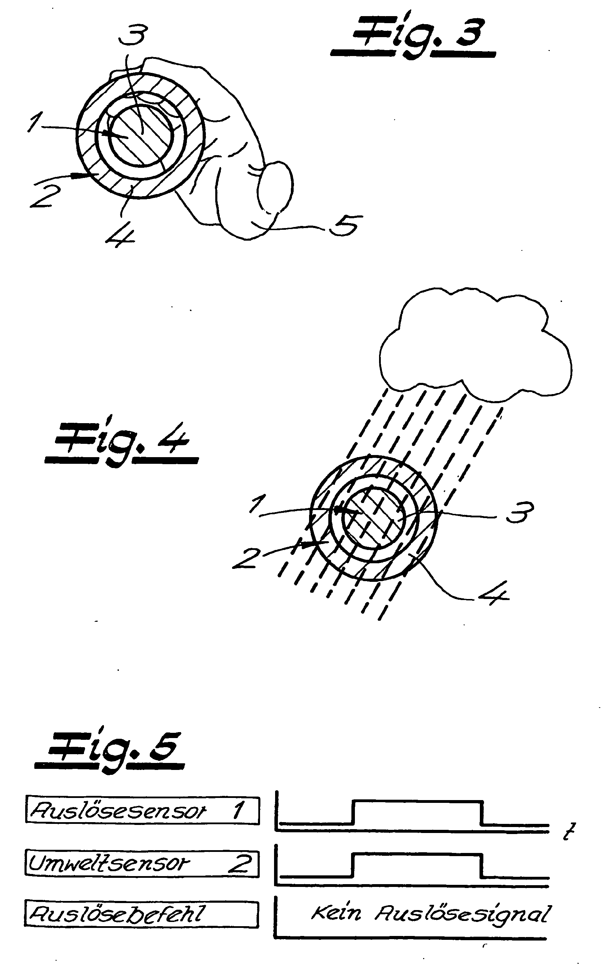

Die von den jeweiligen Sensoren 1, 2 erzeugten Signale sind in den Fig. 2 und 5 dargestellt, wobei jeweils der oberste Signalverlauf das Ausgabesignal des Auslösesensors 1 darstellt, während der mittlere Signalverlauf zu dem Umweltsensor 2 gehört. Der untere Signalverlauf stellt dann den resultierenden Auslösebefehl dar, welcher letztlich für den Öffnungsvorgang der Heckklappe durch elektromotorisches Ausheben der Sperrklinke des Kraftfahrzeugtürverschlusses sorgt.

Da beide Sensoren 1, 2 kapazitiv arbeiten, verfügen sie jeweils über eine in den Fig. 1, 3 und 4 zu erkennende Leitfähigkeitselektrode 3 respektive 4. Die zum Auslösesensor 1 gehörige Leitfähigkeitselektrode 3 und folglich der Auslösesensor 1 weist die Form einer Kreisscheibe auf. Demgegenüber ist die zum Umweltsensor 2 korrespondierende Leitfähigkeitselektrode 4 ringförmig ausgestaltet und umgibt den Auslösesensor 1 bzw. dessen Leitfähigkeitselektrode 3 konzentrisch.

Nähert sich nun die Hand 5 eines Bedieners einer oder beiden Sensoren bzw. den Leitfähigkeitselektroden 3, 4, so wird insgesamt ein Kondensator mit der Kapazität C, einer zugehörigen Plattengröße F und einem Abstand a der jeweiligen Elektroden 3, 5 bzw. 4, 5 gebildet. Die Kapazität C dieses Kondensators genügt der Beziehung:

$$(1) \quad C = \varepsilon \bullet \frac{F}{a}$$

mit $\varepsilon$ der Dielektrizitätskonstanten. Annäherungen der Hand 5 führen also entsprechend der Gleichung (1) zu Kapazitätsänderungen, nämlich einer Erhöhung der Kapazität C, weil bei konstanten Weiten für $\varepsilon$ und F die Verringerung des Abstandes a diese Tatsache nach sich zieht. Die Kapazitätserhöhung kann im Rahmen des Ausführungsbeispiels dadurch erfasst werden, dass der betreffende Kondensator 3, 5 bzw. 4, 5 auf- und/oder entladen wird. Denn hiermit geht die zuvor bereits angesprochene Zeitkonstante $\tau$ einher, die mit der Kapazität C und einem (konstanten) Ladewiderstand R wie folgt zusammenhängt:

$$(2) \quad \tau = C \bullet R.$$

Wenn nun die Kapazität C des Kondensators 3, 5 respektive 4, 5 steigt, so vergrößert sich auch die Zeitkonstante $\tau$ linear in entsprechendem Sinne, der Gleichung (2) folgend. Die Änderung der Zeitkonstante $\tau$ und folglich der Kapazität C lässt sich auswerten, und zwar in einer in Fig. 1 angedeuteten Steuer-/Auswerteeinheit 6.

Die Steuer-/Auswerteeinheit 6 gibt darüber hinaus Schwellwerte für die Kapazitätsänderungen vor, oberhalb derer ein Auslösesignal bzw. Umweltsignal überhaupt registriert wird. Dabei ist der Schwellwert für den Umweltsensor 2 in der Regel geringer eingestellt als für den Auslösesensor 1. Das heißt, Kapazitätsänderungen am Umweltsensor 2 werden eher erfasst bzw. in ein Signal umgesetzt, als dies beim Auslösesensor 1 der Fall ist.

Jedenfalls führen die beschriebenen Kapazitätsänderungen bzw. Kapazitätserhöhungen ausgangsseitig des jeweiligen Auslösesensors 1 bzw. Umweltsensors 2 bzw. nach Aufbereitung durch die Steuer-/Auswerteeinheit 6 dazu, dass sich gleichsam rechteckförmige Signalformen ergeben, wie sie in den Fig. 2 und 5 dargestellt sind.

Sobald die Kapazitätsänderungen am Auslösesensor 1 bzw. zwischen dessen Elektroden 3, 5 den an dieser Stelle relevanten Schwellwert überschritten haben, wird das in Fig. 2 gegenüber der Zeitachse zu erkennende Auslösesignal initiiert. Sobald der betreffende Schwellwert unterschritten wird, fällt das Auslösesignal - wie dargestellt - wieder auf den Ausgangswert zurück. Das gleiche gilt für den Umweltsensor 2.

Wie bereits beschrieben, reagiert der zweite Sensor bzw. Umweltsensor 2 lediglich auf Umwelteinflüsse und gibt beim Vorliegen solcher Umwelteinflüsse, wie beispielsweise in Fig. 4 dargestellt, ein entsprechendes Umweltsignal ab, wie dies der mittlere Verlauf in Fig. 5 ausdrückt. In Abhängigkeit von diesem Umweltsignal wird aus dem Auslösesignal der in den Fig. 2 und 5 jeweils im untersten Teil dargestellte Auslösebefehl abgeleitet. Man erkennt, dass der Umweltsensor im Wesentlichen ein Freigabe- oder Sperrsignal für das Auslösesignal darstellt. Das Freigabesignal des Umweltsensors 2 korrespondiert dazu, dass letztlich kein Umweltsignal erzeugt wird, wie dies in der Fig. 2 in der mittleren Darstellung gezeigt ist. Dagegen korrespondiert das Sperrsignal zu dem Verlauf entsprechend Fig. 5 in der Mitte.

Sobald ein Auslösesignal von dem Auslösesensor 1 entsprechend dem oberen Verlauf in Fig. 2 erzeugt wird, gibt die Steuer-/Auswerteeinheit 6 eine einstellbare Verzögerungszeit T vor (vgl. Fig. 2). Der Beginn dieser Verzögerungszeit T fällt mit dem Beginn des Auslösesignals zusammen. Innerhalb dieser Verzögerungszeit T wertet die Steuer-/Auswerteeinheit 6, an welche die beiden Sensoren 1, 2 angeschlossen sind, nun das Signal des Umweltsensors 2 aus, dem Priorität zukommt.

Liegt kein Umweltsignal vor, gibt der Umweltsensor 2 folglich ein Freigabesignal entsprechend dem mittleren Verlauf nach Fig. 2 ab, so erzeugt die Steuer-/Auswerteeinheit 6 nach Ablauf der Verzögerungszeit T einen Auslösebefehl entsprechend der unteren Darstellung nach Fig. 2. Dieser Auslösebefehl wird solange von der Steuer-/Auswerteeinheit 6 ausgegeben, bis das Auslösesignal des Auslösesensors 1 beendet ist. Das heißt, der Auslösebefehl wird im Anschluss an die Verzögerungszeit T nur solange ausgegeben, wie der Umweltsensor 2 - wie in Fig. 2 dargestellt - das Freigabesignal erzeugt und gleichzeitig ein Auslösesignal am Auslösesensor 1 vorliegt.

Werden jedoch beide Sensoren 1, 2 gleichzeitig ausgelöst, wie dies in den Fig. 3 und 4 bei einer unsachgemäßen Bedienung (vgl. Fig. 3) oder bei Niederschlag (vgl. Fig. 4) der Fall sein kann, so stellt sich der in Fig. 5 dargestellte Signalverlauf für den Auslösesensor 1 und den Umweltsensor 2 dar. Weil in diesem Fall der Umweltsensor 2 ein Umweltsignal abgibt und folglich das Sperrsignal für das Auslösesignal erzeugt, stellt sich ausgangsseitig kein Auslösebefehl ein. Das ist jedenfalls solange der Fall wie der Umweltsensor 2 ein Umweltsignal bzw. Sperrsignal für den Auslösesensor 1 bzw. das Auslösesignal initiiert.

Beide Sensoren 1, 2 mögen entsprechend der Darstellung in unmittelbarer Nähe zueinander angeordnet sein. Es ist aber auch möglich, den Auslösesensor 1 und den Umweltsensor 2 getrennt voneinander im Außenbereich eines Kraftfahrzeuges zu platzieren.

In einer zweiten Ausführungsvariante dient der Umweltsensor 2 dazu, in Abhängigkeit von den Umweltbedingungen die Empfindlichkeit des Auslösesensors 1 einzustellen.

Dabei nimmt das Umweltsignal an Stelle des Zustandes Sperrsignal bei Vorliegen eines Umweltsignales den Zustand Einstellsignal ein. Das Einstellsignal sorgt dafür, dass die Steuer-/Auswerteeinheit 6 dieses Signal auswertet und in Abhängigkeit von dem Einstellsignal eine Einstellung der Empfindlichkeit des Auslösesensors 1 erfolgt.

Sobald ein Auslösesignal von dem Auslösesensor 1 erzeugt wird, gibt die Steuer-/Auswerteeinheit 6 eine einstellbare Verzögerungszeit T vor. Der Beginn dieser Verzögerungszeit T kann mit dem Beginn des Auslösesignals zusammenfallen. Innerhalb dieser Verzögerungszeit T wertet die Steuer-/Auswerteeinheit 6, an welche die beiden Sensoren 1, 2 angeschlossen sind, nun das Signal des Umweltsensors 2 aus, stellt gegebenenfalls die Empfindlichkeit des Auslösesensors 1 ein und wertet ein Auslösesignal des Auslösesensors 1 aus.

Ein Auslösebefehl erfolgt in diesem Fall erst dann, wenn der von der Steuer-/Auswerteeinheit 6 neu eingestellte Schwellwert durch eine Kapazitätsänderung am Auslösesensor 1 überschritten wird und damit ein Auslösesignal anliegt.

Mit dieser Ausführungsvariante werden durch Umweltbedingungen hervorgerufene Kapazitätsveränderungen softwaremäßig dahingehend verarbeitet, das eine Anpassung der Empfindlichkeit des Auslösesensors (1) an diese Umweltbedingungen zur Sicherung seiner Funktionsfähigkeit erfolgt.

**Patentansprüche**

1. Auslösesignalgeber, beispielsweise zur Einleitung eines Frage-/Antwort-Dialoges im Rahmen einer Zugangsberechtigungsprüfung bei einem Kraftfahrzeug, zur Betätigung eines Kraftfahrzeugtürverschlusses, mit wenigstens einem ersten und einem zweiten jeweils kapazitiv arbeitenden Sensor (1, 2), wobei der erste Sensor (1) als Auslösesensor (1) ausgebildet ist und ein Auslösesignal erzeugt, und der zweite Sensor (2) als lediglich auf Umwelteinflüsse reagierender Umweltsensor (2) ausgebildet ist und ein Umweltsignal abgibt, **dadurch gekennzeichnet, dass** eine Steuer-/Auswerteeinheit (6) vorgesehen ist, welche beide Signale der Sensoren (1, 2) auswertet und in Abhängigkeit vom Umweltsignal aus dem Auslösesignal ein Auslösebefehl abgeleitet wird, wobei dem Umweltsignal die Priorität zukommt.

2. Auslösesignalgeber nach Anspruch 1, **dadurch gekennzeichnet, dass** der Umweltsensor (2) im Wesentlichen ein Freigabe- oder Sperrsignal für das Auslösesignal erzeugt.

3. Auslösesignalgeber nach Anspruch 1 oder 2, **dadurch gekennzeichnet, dass** das Auslösesignal erst nach einer einstellbaren Verzögerungszeit (T) in einen Auslösebefehl umgewandelt wird.

4. Auslösesignalgeber nach Anspruch 3, **dadurch gekennzeichnet, dass** der Beginn der Verzögerungszeit (T) mit dem Start des Auslösesignals zusammenfällt.

5. Auslösesignalgeber nach einem der Ansprüche 1 bis 4, **dadurch gekennzeichnet, dass** der Auslösebefehl nur dann ausgegeben wird, wenn der Umweltsensor (2) das Freigabesignal erzeugt und gleichzeitig ein Auslösesignal am Auslösesensor (1) vorliegt.

6. Auslösesignalgeber nach einem der Ansprüche 1 bis 5, **dadurch gekennzeichnet, dass** bei Vorliegen eines Sperrsignals am Umweltsensor (2) kein Auslösebefehl ausgegeben wird.

7. Auslösesignalgeber nach einem der Ansprüche 1 bis 6, **dadurch gekennzeichnet, dass** der Auslösesensor (1) und der Umweltsensor (2) in unmittelbarer Nähe zueinander angeordnet sind und beispielsweise eine konzentrische Anordnung aufweisen.

8. Auslösesignalgeber nach einem der Ansprüche 1 bis 7, **dadurch gekennzeichnet, dass** der Auslösesensor (1) und der Umweltsensor (2) beispielsweise im Türgriff, in oder an der Heckklappe, in oder an einem Stoßfänger oder an anderen Einbauorten des Kraftfahrzeuges getrennt oder gemeinsam angebracht sind.

9. Auslösesignalgeber nach einem der Ansprüche 1 bis 8, **dadurch gekennzeichnet, dass** der Auslösesensor (1) und der Umweltsensor (2) jeweils eine Leitfähigkeitselektrode (3, 4) aufweisen.

10. Auslösesignalgeber nach Anspruch 1 **dadurch gekennzeichnet, dass** der Umweltsensor (2) ein Signal an die Steuer-/Auswerteeinheit zur Einstellung der Empfindlichkeit des Auslösesensors (1) erzeugt.

11. Auslösesignalgeber nach Anspruch 10 **dadurch gekennzeichnet, dass** der Auslösebefehl dann ausgegeben wird, wenn der Umweltsensor (2) entweder kein Signal erzeugt oder ein Signal an die Steuer-/Auswerteeinheit zur Einstellung der Empfindlichkeit des Auslösesensors (1) erzeugt und danach gleichzeitig ein Auslösesignal am Auslösesensor (1) vorliegt.

**Claims**

1. A trigger signal emitter, for initiating a question and answer dialogue in the context of an access authorisation check in the case of a vehicle, for activating a vehicle door lock, for example, with at least one first and one second capacitive sensor (1, 2) in each case, wherein the first sensor (1) is designed as the trigger sensor (1) and produces a trigger signal, and the second sensor (2) is designed as an environment sensor (2) that only reacts to environmental influences and emits an environment signal, **characterised in that** a control/evaluation unit(6) is provided, which evaluates both signals from the sensors (1, 2) and, depending on the environment signal, a trigger command is derived from the trigger signal, wherein priority is given to the environment signal.

2. The trigger signal emitter according to claim 1, **characterised in that** the environment sensor (2) essentially generates a release or blocking signal for the trigger signal.

3. The trigger signal emitter according to claim 1 or 2, **characterised in that** the trigger signal is only converted into a trigger command after an adjustable delay time (T).

4. The trigger signal emitter according to claim 3, **characterised in that** the start of the delay time (T) coincides with the start of the trigger signal.

5. The trigger signal emitter according to one of the claims 1 to 4, **characterised in that** the trigger command is only emitted when the environment sensor (2) generates the release signal and a trigger signal is present at the trigger sensor (1) at the same time.

6. The trigger signal emitter according to one of the claims 1 to 5, **characterised in that** no trigger command is emitted when a blocking signal is present at the environment sensor (2).

7. The trigger signal emitter according to one of the claims 1 to 6, **characterised in that** the trigger sensor (1) and the environment sensor (2) are disposed in close proximity to one another and exhibit a concentric arrangement, for example.

**8.** The trigger signal emitter according to one of the claims 1 to 7, **characterised in that** the trigger sensor (1) and the environment sensor (2) are fitted either separately or together in the door handle, in or on the boot lid, in or on a bumper or at other installation points in the vehicle, for example.

**9.** The trigger signal emitter according to one of the claims 1 to 8, **characterised in that** the trigger sensor (1) and the environment sensor (2) each exhibit a conductivity electrode (3, 4).

**10.** The trigger signal emitter according to claim 1, **characterised in that** the environment sensor (2) generates a signal to the control/evaluation unit to adjust the sensitivity of the trigger sensor (1).

**11.** The trigger signal emitter according to claim 10, **characterised in that** the trigger command is emitted when the environment sensor (2) either generates no signal or generates a signal to the control/evaluation unit to adjust the sensitivity of the trigger sensor (1) and thereafter a trigger signal is present at the trigger sensor (1) at the same time.

**Revendications**

**1.** Générateur de signal de déclenchement, par exemple pour l'amorçage d'un dialogue sous forme de question/réponse dans le cadre d'un contrôle d'autorisation d'accès pour un véhicule, pour l'actionnement d'une fermeture de porte de véhicule, comprenant au moins un premier et un second capteur (1, 2) travaillant chacun de façon capacitive, le premier capteur (1) étant conçu comme capteur de déclenchement (1) et générant un signal de déclenchement, et le second capteur (2) étant conçu comme capteur d'environnement (2) réagissant uniquement à des influences de l'environnement et délivrant ainsi un signal d'environnement, **caractérisé en ce qu'**une unité de commande/analyse (6) est prévue, qui analyse les deux signaux des capteurs (1, 2) et une instruction de déclenchement est déduite du signal de déclenchement en fonction du signal d'environnement, la priorité étant donnée au signal d'environnement.

**2.** Générateur de signal de déclenchement selon la revendication 1, **caractérisé en ce que** le capteur d'environnement (2) génère essentiellement un signal d'autorisation ou de blocage pour le signal de déclenchement.

**3.** Générateur de signal de déclenchement selon la revendication 1 ou 2, **caractérisé en ce que** le signal de déclenchement n'est transformé en une instruction de déclenchement qu'après une temporisation (T) réglable.

**4.** Générateur de signal de déclenchement selon la revendication 3, **caractérisé en ce que** le début de la temporisation (T) coïncide avec le démarrage du signal de déclenchement.

**5.** Générateur de signal de déclenchement selon l'une quelconque des revendications 1 à 4, **caractérisé en ce que** l'instruction de déclenchement n'est sortie que dans le cas où le capteur d'environnement (2) génère le signal de validation et qu'on a en même temps un signal de déclenchement sur le capteur de déclenchement (1).

**6.** Générateur de signal de déclenchement selon l'une quelconque des revendications 1 à 5, **caractérisé en ce qu'**aucune instruction de déclenchement n'est sortie en cas de présence d'un signal de blocage sur le capteur d'environnement (2).

**7.** Générateur de signal de déclenchement selon l'une quelconque des revendications 1 à 6, **caractérisé en ce que** le capteur de déclenchement (1) et le capteur d'environnement (2) sont disposés à proximité immédiate l'un de l'autre et présentent par exemple un agencement concentrique.

**8.** Générateur de signal de déclenchement selon l'une quelconque des revendications 1 à 7, **caractérisé en ce que** le capteur de déclenchement (1) et le capteur d'environnement (2) sont placés séparément ou conjointement par exemple dans la poignée de porte, dans ou sur le hayon arrière, dans ou sur un pare-chocs ou sur d'autres emplacements de montage du véhicule.

**9.** Générateur de signal de déclenchement selon l'une quelconque des revendications 1 à 8, **caractérisé en ce que** le capteur de déclenchement (1) et le capteur d'environnement (2) présentent chacun une électrode de conductibilité (3, 4).

**10.** Générateur de signal de déclenchement selon la revendication 1, **caractérisé en ce que** le capteur d'environnement (2) génère un signal destiné à l'unité de commande/analyse pour le réglage de la sensibilité du capteur de déclenchement (1).

**11.** Générateur de signal de déclenchement selon la revendication 10, **caractérisé en ce que** l'instruction de déclenchement est sortie uniquement dans les cas où le capteur d'environnement (2) soit ne génère pas de signal soit génère un signal destiné à l'unité de commande/analyse pour le réglage de la sensibilité du capteur de déclenchement (1) et on a ensuite en même temps un signal de déclenchement sur le capteur de déclenchement (1).

## Fig.1

3

1

2

4

5

6

## Fig.2

Auslösesignal

| Auslösesensor 1 |
| Umweltsensor 2 |
| Auslösebefehl |

t

T

Verzögerungszeit (per Software)

Fig. 3

Fig. 4

Fig. 5

| Auslösesensor 1 | |
| --- | --- |
| Umweltsensor 2 | |
| Auslösebefehl | Kein Auslösesignal |

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1235190 A1
- DE 19620059 A1

- US 6075294 A